# EUROPÄISCHE PATENTSCHRIFT

(11) **EP 3 819 645 B1**
(45) Veröffentlichungstag und Bekanntmachung des Hinweises auf die Patenterteilung: **26.02.2025**
(21) Anmeldenummer: 20194123.4
(22) Anmeldetag: 02.09.2020
(51) Int. Cl.: G01R 1/04, G01R 31/28

(54) **VERSTEIFUNGSELEMENT ZUM VERSTEIFEN EINES TESTKONTAKTORSYSTEMS, VERWENDUNG UND VERFAHREN ZUR MONTAGE EINES TESTKONTAKTORSYSTEMS**
REINFORCEMENT ELEMENT FOR REINFORCING A TEST CONTACTOR SYSTEM, USE AND METHOD FOR MOUNTING A TEST CONTACTOR SYSTEM
ÉLÉMENT DE RENFORT PERMETTANT DE RENFORCER UN SYSTÈME DE CONTACTEUR D'ESSAI, UTILISATION ET PROCÉDÉ DE MONTAGE D'UN SYSTÈME DE CONTACTEUR D'ESSAI

(30) Priorität: 11.11.2019 DE 102019007802
(43) Veröffentlichungstag der Anmeldung: 12.05.2021
(73) Patentinhaber: Yamaichi Electronics Deutschland GmbH, 85609 Aschheim-Dornach (DE)
(72) Erfinder: QUITER, Michael, 57482 Wenden (DE); GOLI, Ghassene, 4000 Sousse (TN); CHAKCHOUK, Skander, 4000 Sousse (TN)
(74) Vertreter: Müller-Boré & Partner Patentanwälte PartG mbB

(56) Entgegenhaltungen:
- WO-A1-2012/099572
- DE-A1- 102010 004 387
- US-A1- 2014 232 425

## Beschreibung

Die Erfindung betrifft ein Versteifungselement zum Versteifen eines Testkontaktorsystems, eine Verwendung eines Versteifungselements zum Versteifen eines Testkontaktorsystems sowie ein Verfahren zur Montage eines Testkontaktorsystems.

Herkömmliche Testkontaktorsysteme bestehen im Wesentlichen aus einem Testkontaktor und einer Leiterplatine und dienen zum Testen von Chips, wie beispielsweise Rechenchips die als CPU-Kerne verwendet werden. Dazu wird ein Chip in den geöffneten Testkontaktor eingesetzt bzw. eingelegt und anschließend wird der Testkontaktor geschlossen. Der Testkontaktor ist dabei auf einer Leiterplatine angeordnet, so dass beim Schließen des Testkontaktors ein Deckel des Testkontaktors Druck auf den Chip ausübt, so dass der Chip Federkontaktstifte des Testkontaktors zuverlässig kontaktiert. Hierbei gibt der Chip den Druck durch die Federkontaktstifte auf die Leiterplatine weiter, so dass auch die Federkontaktstifte zuverlässig mit der Leiterplatine kontaktiert werden.

Als Folge kann sich die Leiterplatine verformen. Verformt sich die Leiterplatine, kann es passieren, dass die Federkontaktstifte nicht mehr sicher bzw. zuverlässig beim Ausführen des Tests mit der Leiterplatine kontaktieren, und/oder die Leiterplatine plastisch verformt oder sogar bricht, wodurch ein zu testender Chip nicht zuverlässig getestet werden kann.

Die Leiterplatinen für Testkontaktorsysteme müssen somit häufig gewechselt werden, um Tests mit einem zuverlässigen Ergebnis durchführen zu können, was dementsprechend zu geringen Lebensdauern für Leiterplatinen führt, wodurch hohe Kosten für den Ersatz der Leiterplatinen sowie ein hoher wiederkehrender Aufwand zur Montage von Leiterplatinen in Testkontaktorsystemen entstehen.

DE 10 2010 004 387 A1 beschreibt einen Testkontaktor für ein integriertes Schaltkreisbauteil, umfassend eine Aufnahmevorrichtung, die ausgelegt ist, das integrierte Schaltkreisbauteil entlang einer Einführrichtung aufzunehmen, ein Andruckelement und eine Verriegelungsvorrichtung, wobei mittels des Andruckelements in einer Betriebsposition eine Andruckkraft entlang der Einführrichtung auf das Schaltkreisbauteil anlegbar ist, wobei das Andruckelement durch eine lineare Verschiebung entlang der Einführrichtung relativ zur Aufnahmevorrichtung von einer Geschlossenposition in die Betriebsposition überführbar ist, und wobei das Andruckelement in der Betriebsposition mittels der Verriegelungsvorrichtung verriegelt ist.

US 2014/0232425 A1 beschreibt einen Kontaktor, der einen Pogo-Block in einer ersten Konfiguration als direkten Testsockel für integrierte Schaltungen verwendet, wobei der Kontaktor umkonfiguriert werden kann, um eine Pogo-Block-Baugruppe bereitzustellen, um eine Schnittstelle zwischen einer Haupttestleiterplatte und einer Tochterkarte bereitzustellen, für spezifische Geräte-Händler und/oder einen spezifischen Gehäusetyp, der sich von der Haupttestleiterplatte unterscheiden kann. Ein Pogo-Block wird in einen dicken Rahmen mit einer Ausrichtungsplatte zur Verwendung als Kontaktor eingesetzt, wobei ein Prüfling durch eine Ausrichtungsplatte in eine Aussparung im Rahmen passt, um den Prüfling so auszurichten, dass er mit den elektrischen Kontakten des Kontaktors in Kontakt kommt. Der Rahmen und die Führungsplatte können entfernt werden, und ein dünnerer Rahmen kann mit dem Kontaktor verbunden werden, um seine Funktion für eine Pogo-Block-Baugruppe zu ändern.

WO 2012/099572 A1 beschreibt eine mikroelektronische Kontaktbaugruppe, die einen Sondenkopf mit mikroelektronischen Kontakten zum Kontaktieren von Anschlüssen von Halbleiterbauelementen umfasst, um die Halbleiterbauelemente zu testen. Eine Versteifungsbaugruppe bietet mikroelektronischen Kontaktgebern mechanische Unterstützung und verbindet eine Prüfkartenbaugruppe mit einer Prüfmaschine. Eine Versteifungsbaugruppe umfasst einen Hauptkörper und mehrere Befestigungspunkte, wobei mindestens einer der Befestigungspunkte durch einen oder mehrere sich seitlich erstreckende Träger, die einen Widerstandsmoment normal zur seitlichen Richtung aufweisen, der deutlich größer ist als der Hauptkörper, flexibel mit dem Hauptkörper verbunden ist. Die Versteifungsanordnung ermöglicht eine unterschiedliche Wärmeausdehnung verschiedener Komponenten der mikroelektronischen Kontaktanordnung und minimiert gleichzeitig die damit einhergehende Dimensionsverzerrung, die die Kontaktierung der Anschlüsse von Halbleiterbauelementen beeinträchtigen könnte.

Die Verwendung eines Versteifungselements ist bekannt, jedoch sind Versteifungselemente aufwendig zu montieren.

Es ist daher Aufgabe der vorliegenden Erfindung ein Versteifungselement zum Versteifen eines Testkontaktorsystems bereitzustellen, welches die Lebensdauer von Leiterplatinen erhöht und eine einfache Montage bzw. Fixierung mit Leiterplatinen ermöglicht.

Die vorbeschriebene Aufgabe wird durch die Gegenstände der unabhängigen Ansprüche gelöst, bevorzugte Ausführungsformen sind Gegenstand der abhängigen Ansprüche.

Ein Aspekt der Erfindung betrifft ein Versteifungselement zum Versteifen eines Testkontaktorsystems, umfassend einen Auflageabschnitt an einer Platinenstützseite des Versteifungselements, wobei der Auflageabschnitt ausgebildet ist, um eine Auflage für eine Leiterplatine zu bilden, und zumindest eine Ausnehmung, die an einer Rückseite des Versteifungselements ausgebildet ist, wobei in der zumindest einen Ausnehmung zumindest ein Befestigungselement zumindest bereichsweise zur Befestigung des Versteifungselements mit einem Testkontaktor angeordnet, insbesondere verliersicher angeordnet, ist. Mit anderen Worten ist zumindest ein bereichsweiser Abschnitt des Befestigungselements, also ein Befestigungselementabschnitt, in der zumindest einen Ausnehmung angeordnet, insbesondere verliersicher angeordnet.

Vorteilhafterweise ermöglicht das vorbeschriebene Versteifungselement, dass das Testkontaktorsystem, und insbesondere die Leiterplatine versteift wird. Durch den Auflageabschnitt, der an der Platinenstützseite des Versteifungselements bereitgestellt ist, wird eine Auflage für die Leiterplatine gebildet, so dass sich die Leiterplatine beim Schließen des Testkontaktorsystems weniger, insbesondere nicht, durchdrückt. Durch die Verringerung oder die Vermeidung des Durchdrückens der Leiterplatine beim Schließen des Testkontaktorsystems kann eine Verformung einer Leiterplatine, auch bei wiederholten Tests und damit einhergehenden Druckbelastungen, verringert bzw. vermieden werden, wodurch die Lebensdauer der Leiterplatine für Testkontaktorsysteme erhöht wird.

Weiterhin wird, durch die verliersichere Anordnung des zumindest einen Befestigungselements zur Befestigung des Versteifungselements mit dem Testkontaktor, vorteilhafterweise ermöglicht, dass die Leiterplatine mit dem Versteifungselement vorkonfektioniert bzw. vormontiert werden kann, ohne dass das zumindest eine Befestigungselement, das in der zumindest einen Ausnehmung angeordnet ist, herausfällt bzw. verloren geht. Dadurch kann bei der Vorkonfektionierung bzw. der Vormontage die Leiterplatine auf dem Versteifungselement, und insbesondere auf dem Auflageabschnitt des Versteifungselements, aufgelegt werden, ohne dass für die weitere Montage die Erreichbarkeit des zumindest einen Befestigungselements beeinträchtigt wird. Dies ist bei Leiterplatinen allgemein, und insbesondere bei größeren Leiterplatinen sinnvoll, wobei mit größeren Leiterplatinen, Leiterplatinen gemeint sind, die Seitenabmessungen im Wesentlichen größer als 5 cm, insbesondere größer als 10 cm, denkbar insbesondere auch größer als 50 cm oder 80 cm, aufweisen, insbesondere Leiterplatinen mit mehr als einem Testkontaktor, beispielsweise mit mehr als 10 Testkontaktoren, und somit Leiterplatinen mit mehr als einem Versteifungselement, beispielsweise mehr als 10 Versteifungselementen. Somit kann durch das vorbeschriebene Versteifungselement die Montage des Testkontaktorsystems effektiv vereinfacht bzw. erleichtert werden.

Das zumindest eine Befestigungselement kann vollständig in der zumindest einen Ausnehmung angeordnet werden oder bereichsweise in der zumindest einen Ausnehmung angeordnet werden. Bei einer bereichsweisen Anordnung des zumindest einen Befestigungselements kann ein Teil bzw. Abschnitt des zumindest einen Befestigungselements, mit anderen Worten ein Befestigungselementabschnitt, innerhalb der zumindest einen Ausnehmung angeordnet sein und ein anderer Teil bzw. Abschnitt des zumindest einen Befestigungselements außerhalb der zumindest einen Ausnehmung angeordnet sein. So kann das zumindest eine Befestigungselement beispielsweise in der zumindest einen Ausnehmung umspritzt werden, wie zum Beispiel durch einen Spritzgießvorgang oder durch ein Ausschäumen der zumindest einen Ausnehmung.

Im weiteren Verlauf werden verschiedene Begriffe wiederholt verwendet, deren Verständnis durch die nachfolgenden Definitionen erleichtert werden soll. Lösbar bzw. wiederlösbar verbindbar/verbunden: Als lösbar bzw. wiederlösbar verbindbar/verbunden werden Verbindungen mindestens zweier Elemente bezeichnet, die nach dem Verbinden gelöst werden können, wobei die mindestens zwei Elemente im Anschluss an das Lösen, ohne weitere Veränderung, wieder miteinander verbunden werden können. Das Lösen bzw. Wiederlösen der lösbaren bzw. wiederlösbaren Verbindung mindestens zweier Elemente geschieht somit im Wesentlichen ohne Beschädigung, insbesondere ohne Beschädigung der an der Verbindung beteiligten Elemente.

Platinenstützseite des Versteifungselements: Die Platinenstützseite des Versteifungselements ist eine Seite des Versteifungselements, an der der Auflageabschnitt zur Auflage für die Leiterplatine ausgebildet ist. Während der Montage des Testkontaktorsystems bzw. im montierten Zustand des Testkontaktorsystems stellt die Platinenstützseite des Versteifungselements, im Folgenden häufig nur als Platinenstützseite bezeichnet, somit eine Seite des Versteifungselements dar, die der Leiterplatine im Wesentlichen zugewandt bzw. zugewandt ist.

Rückseite des Versteifungselements: Die Rückseite des Versteifungselements ist eine Seite des Versteifungselements, die mit Bezug auf das Versteifungselement im Wesentlichen gegenüber dem Auflageabschnitt, zur Auflage für die Leiterplatine, ausgebildet ist. Während der Montage des Testkontaktorsystems bzw. im montierten Zustand des Testkontaktorsystems stellt die Rückseite des Versteifungselements somit eine Seite des Versteifungselements dar, die der Leiterplatine abgewandt ist. Mit anderen Worten ist die Rückseite des Versteifungselements im Allgemeinen einer Unterlage für das Testkontaktorsystem zugewandt. Im Folgenden wird die Rückseite des Versteifungselements häufig auch nur als Rückseite bezeichnet.

Verliersicher: Der Begriff der Verliersicherheit wird wenn dann meist im Zusammenhang mit dem zumindest einen Befestigungselement verwendet. Ein verliersicheres Element fällt, unabhängig von der Stellung bzw. Position des Bereichs, in dem das verliersichere Element angeordnet ist, wie beispielsweise auf den Kopf, schräg, verkippt, etc., aus diesem Bereich nicht heraus bzw. geht von dort nicht verloren. Mit anderen Worten hält ein verliersicheres Element einer vorbestimmten Auszugskraft stand, insbesondere der Schwerkraft des verliersicheren Elements.

Verdrehsicher: Der Begriff der Verdrehsicherung wird wenn dann meist im Zusammen mit dem zumindest einen Befestigungselement verwendet. Ein verdrehsicheres Element kann in dem Bereich, in dem es angeordnet ist, bei der Anwendung von Kräften und Momenten, wie für die Montage des Testkontaktorsystems üblich, sowie in einem bestimmten Bereich darüber hinaus, nicht verdreht werden, zumindest nicht ohne Beschädigung des Elements bzw. Bereichs in dem es angeordnet ist.

Das Versteifungselement gemäß des ersten Aspekts weist an der Platinenstützseite zumindest ein Fixierelement auf, um das Versteifungselement an der Leiterplatine zu fixieren.

Vorteilhafterweise ermöglicht das Fixierelement, dass das Versteifungselement an der Leiterplatine fixierbar ist, so dass eine sichere Vorkonfektionierung bzw. Vormontage des Versteifungselements mit der Leiterplatine ermöglicht wird. Für die Vormontage kann dazu das Versteifungselement an die Leiterplatine, oder die Leiterplatine an das Versteifungselement gedrückt werden, wobei sich das zumindest eine Fixierelement zumindest vorübergehend verformt, wodurch die aus der Verformung entstehende Rückstellkraft oder die aus der Verformung resultierende Verklemmung eine Fixierung zwischen dem Versteifungselement und der Leiterplatine bewirkt. Beispielsweise kann es sich bei dem Fixierelement um einen Cliparm mit Rückhaltevorsprung handeln, der sich vorübergehend, während dem Drücken der Leiterplatine auf das Versteifungselement bzw. des Versteifungselements auf der Leiterplatine verformt und anschließend wieder in die ursprüngliche Stellung gelangt, wodurch das Versteifungselement an der Leiterplatine mittels Formschluss fixiert wird. Hierfür kann der Cliparm mit Rückhaltevorsprung bevorzugt elastisch ausgebildet sein. Wahlweise kann das Fixierelement auch als ein Fixiervorsprung ausgebildet sein, der ein Übermaß gegenüber der Geometrie der Leiterplatine, bevorzugt einer Wand einer zumindest einen Öffnung oder einer Seitenwand der Leiterplatine aufweist. Durch das Übermaß des Fixiervorsprungs gegenüber der Geometrie der Leiterplatine wird der Fixiervorsprung gedrückt und dabei elastisch oder plastisch verformt, wodurch eine Klemmung, insbesondere ein Kraftschluss bzw. ein Reibschuss, als Fixierung zwischen dem Versteifungselement und der Leiterplatine entsteht.

Vorteilhafterweise ermöglicht die Fixierung des Versteifungselements an der Leiterplatine mittels des zumindest einen Fixierelements, dass Versteifungselement und Leiterplatine für die weitere Montage vorkonfektioniert bzw. vormontiert sind, und dadurch für die weitere Montage leicht handhabbar sind. Die Fixierung des Versteifungselements an der Leiterplatine kann grundsätzlich als eine lösbare bzw. wiederlösbare Verbindung oder auch nicht lösbare bzw. nicht wiederlösbare Verbindung ausgestaltet sein. Während eine nicht lösbare bzw. nicht wiederlösbare Verbindung als Fixierung des Versteifungselements an der Leiterplatte eine besonders sichere Fixierung darstellt, ermöglicht eine lösbare bzw. wiederlösbare Verbindung als Fixierung des Versteifungselements an der Leiterplatine, dass im Schadensfall eines von beiden, also das Versteifungselement oder die Leiterplatine, weiterverwendet werden können und nur das beschädigte Teil von beiden auszuwechseln ist.

Vorteilhafterweise ermöglicht die Fixierung des Versteifungselement an der Leiterplatine weiterhin, dass durch die Fixierung im Zuge der Vorkonfektionierung bzw. der Vormontage von Versteifungselement und Leiterplatte, eine Position des Auflageabschnitts zu der Leiterplatine definiert und für die weitere Montage sicher eingehalten werden kann. Die Lebensdauer der Leiterplatine kann durch die definierte Auflage durch den Auflageabschnitt zuverlässig erhöht werden. Durch eine definierte bzw. vorbestimmte Ausrichtung, der Leiterplatine zum Versteifungselement, insbesondere des Auflageabschnitts des Versteifungselements zur Leiterplatine, entsteht eine besondere Eignung von Versteifungselement und Leiterplatine als modularer Bestandteil des Testkontaktorsystems.

Vorzugsweise tritt das zumindest eine Befestigungselement durch zumindest eine Öffnung in dem Versteifungselement in Richtung der Platinenstützseite des Versteifungselements hindurch, wobei das zumindest eine Befestigungselement konfiguriert ist, durch zumindest eine Leiterplatinenöffnung durch die Leiterplatine hindurchzutreten, und wobei das zumindest eine Befestigungselement mit zumindest einem komplementären Befestigungsgegenelement des Testkontaktors lösbar bzw. wiederlösbar verbindbar ist.

Vorteilhafterweise ermöglicht das Hindurchtreten des zumindest einen Befestigungselements durch die zumindest eine Öffnung in dem Versteifungselement, dass das zumindest eine Befestigungselement für die weitere Montage besonders gut zugänglich, insbesondere auf der Platinenstützseite besonders gut zugänglich ist. Weiterhin ermöglicht das Hindurchtreten des zumindest einen Befestigungselements durch die zumindest eine Leiterplatinenöffnung, dass das zumindest eine Befestigungselement auch nach der Vorkonfektionierung bzw. der Vormontage von Versteifungselement und Leiterplatine besonders gut zugänglich ist. Die zumindest eine Leiterplatinenöffnung stellt zusätzlich eine vorteilhafte Möglichkeit zur definierten bzw. vorbestimmten Ausrichtung der Leiterplatine und des Versteifungselements zueinander dar, was wiederum die Eignung von Versteifungselement und Leiterplatine als modulare Bestandteile im Testkontaktorsystem erhöht.

Weiterhin vorteilhaft kann das zumindest eine Befestigungselement durch das Hindurchtreten durch die zumindest eine Leiterplatinenöffnung besonders einfach mit dem zumindest einen komplementären Befestigungsgegenelement des Testkontaktors verbunden werden, wodurch eine einfache Montage für das Testkontaktorsystem als Ganzes ermöglicht wird. Die Lösbarkeit bzw. Wiederlösbarkeit der Verbindung zwischen dem zumindest einen Befestigungselement und dem zumindest einen komplementären Testkontaktorbefestigungsgegenelement bzw. Befestigungsgegenelement des Testkontaktors ermöglicht weiterhin vorteilhaft, dass verschiedene Testkontaktoren wiederlösbar mit dem Versteifungselement, und insbesondere mit dem an der Leiterplatine vorkonfektionierten bzw. vormontierten Versteifungselement, verbunden werden können. Dadurch wird die einfache Montage weiterhin verbessert und die Modularität des Testkontaktorsystems weiterhin gesteigert.

Vorzugsweise ist das zumindest eine Befestigungselement drehfest in der zumindest einen Ausnehmung angeordnet.

Vorteilhafterweise ermöglicht die drehfeste Anordnung des zumindest einen Befestigungselements in der zumindest einen Ausnehmung des Versteifungselements, dass eine Verbindung des zumindest einen Befestigungselements mit dem zumindest einen komplementären Befestigungsgegenelement des Testkontaktors, allein durch eine Betätigung, wie beispielsweise ein Drehen oder Schrauben, des zumindest einen komplementären Befestigungsgegenelements erreichbar ist. Da die Drehung des zumindest einen Befestigungselements verhindert wird, kann beispielsweise ein Drehen des zumindest einen komplementären Befestigungsgegenelements genügen, um das zumindest eine komplementäre Befestigungsgegenelement mit dem zumindest einen Befestigungselement zu verbinden, wodurch ein möglicherweise notwendiges Halten des zumindest einen Befestigungselements nicht mehr notwendig ist, und somit die Montage des Testkontaktorsystems weiterhin vereinfacht wird.

Vorzugsweise ist das zumindest eine Fixierelement als eine Mehrzahl von Fixiervorsprüngen ausgebildet, die in einer Montagerichtung hin zu der Leiterplatine ausgehend von dem Versteifungselement vorstehen, wobei das Versteifungselement mittels der Mehrzahl von Fixiervorsprüngen reibschlüssig mit der Leiterplatine verbindbar ist, und/oder das Versteifungselement mittels der Mehrzahl von Fixiervorsprüngen formschlüssig mit der Leiterplatine verbindbar ist.

Vorteilhafterweise ermöglicht das zumindest eine Fixierelement, welches als eine Mehrzahl von Fixiervorsprüngen ausgebildet ist, die in einer Montagerichtung hin zu der Leiterplatine ausgehend von dem Versteifungselement vorstehen, dass bei der Vorkonfektionierung bzw. der Vormontage von Versteifungselement und Leiterplatine mehrere Fixiervorsprünge hin zu der Leiterplatine vorstehen und die Leiterplatine dadurch an mehreren Stellen definiert fixieren können. Die Ausbildung des zumindest einen Fixierelements als eine Mehrzahl von Fixiervorsprüngen stellt dadurch eine gezielte Vormontage zwischen Versteifungselement und Leiterplatine sicher. Weiterhin kann die Ausbildung des zumindest einen Fixierelements als eine Mehrzahl von Fixiervorsprüngen die Verformbarkeit, insbesondere die elastische und plastische Verformbarkeit, des Fixierelements erhöhen, wodurch die Montage zwischen Versteifungselement und Leiterplatine zusätzlich vereinfacht wird.

Während eine reibschlüssige Verbindung durch die Mehrzahl von Fixiervorsprüngen des Versteifungselements mit der Leiterplatine vorteilhaft ermöglicht, dass kein Hintergreifen der Leiterplatine nötig ist, die Leiterplatine also von der dem Versteifungselement abgewandten Seite besonders gut zugänglich ist, ermöglicht eine formschlüssige Verbindung durch die Mehrzahl von Fixiervorsprüngen des Versteifungselements mit der Leiterplatine vorteilhaft, dass die Verbindung, beispielsweise durch ein Hintergreifen der Mehrzahl von Fixiervorsprüngen an der Leiterplatine, nicht nur sicher, sondern während der Montage auch erkennbar sicher ist. Die Erkennbarkeit der Verbindung kann dabei sowohl optisch als auch akustisch, beispielsweise durch ein Klickgeräusch, erfolgen. Eine Kombination einer reibschlüssigen Verbindung und einer formschlüssigen Verbindung durch die Mehrzahl von Fixiervorsprüngen des Versteifungselements mit der Leiterplatine ist ebenfalls denkbar und kann dadurch die Vorteile der Verbindungsarten miteinander verknüpfen.

Vorzugsweise sind vier Ausnehmungen auf der Rückseite des Versteifungselements ausgebildet, wobei die vier Ausnehmungen wahlweise rechteckig, insbesondere quadratisch, vieleckig, insbesondere sechseckig, oder kreisförmig auf der Rückseite des Versteifungselements ausgebildet sind, und weiterhin wahlweise der Auflageabschnitt geometrisch mittig zu den vier Ausnehmungen angeordnet ist.

Vorteilhafterweise ermöglichen die vier Ausnehmungen, die auf der Rückseite des Versteifungselements ausgebildet sind, dass eine Mehrzahl von Befestigungselementen in den vier Ausnehmungen angeordnet werden kann, wodurch eine sichere Möglichkeit zur Montage des Testkontaktorsystems bereitgestellt wird. Die geometrische Ausbildung der Ausnehmungen, insbesondere der vier Ausnehmungen, ermöglicht weiterhin vorteilhafterweise, dass unterschiedliche Befestigungselemente zur Anordnung darin geeignet sind, und dass gleichzeitig verschiedene Eigenschaften, wie beispielsweise eine Verdrehsicherung der darin angeordneten zumindest einen Befestigungselemente, integral einhergehen. So eignet sich insbesondere eine sechseckige Ausnehmung, in anderen Worten eine Ausnehmung mit sechseckigen Querschnitt, um ein Befestigungselement wie beispielsweise eine metrische Schraube mit Sechskantkopf darin anzuordnen. Demgegenüber eignet sich eine kreisförmige Ausnehmung, in anderen Worten also eine Ausnehmung mit kreisförmigem Querschnitt, dass ein Befestigungselement mit beliebiger Geometrie darin angeordnet werden kann. Beispielsweise kann die Ausnehmung in Leiterplatinenrichtung, d.h. senkrecht zu einer Leiterplatinenebene bzw. in einer Montagerichtung des Versteifungselements an die Leiterplatine, auch konisch geformt sein, so dass beim Anordnen des Befestigungselements in der Ausnehmung ein Verpressen stattfindet, wodurch das Befestigungselement sowohl verliersicher, als gegebenenfalls auch drehfest in der Ausnehmung angeordnet werden kann. Weiterhin sind auch Kombinationen der geometrischen Ausführung der Ausnehmungen möglich, so dass die Geometrische der Ausnehmung, also insbesondere der Querschnitt der Ausnehmung, abschnittsweise wechselt. Außerdem können die Befestigungselemente auch direkt integral mit dem Versteifungselement gefertigt werden, wodurch sich die Geometrie der Ausnehmungen entsprechend der Geometrie der Befestigungselemente ergeben. Dies kann beispielsweise durch einen Mehrkomponentenspritzguss geschehen. Weiterhin können die Befestigungselemente auch einstückig mit dem Versteifungselement gefertigt werden, indem die Befestigungselemente im gleichen bzw. selben Verfahren wie das Versteifungselement, beispielsweise im Spritzguss, hergestellt werden.

Vorteilhafterweise ermöglicht die geometrisch mittige Anordnung des Auflageabschnitts zu den Ausnehmungen, insbesondere den vier Ausnehmungen, dass nach Verbindung des zumindest einen Befestigungselements mit dem zumindest einen komplementären Befestigungsgegenelement, die Last während einem Testzyklus des Testkontaktorsystems gleichmäßig verteilt wird und insbesondere gleichmäßig über den Auflageabschnitt abgeleitet werden kann.

Vorteilhafterweise ermöglicht die geometrisch mittige Anordnung des Auflageabschnitts zu den Ausnehmungen, insbesondere den vier Ausnehmungen, weiterhin, dass das Versteifungselement in verschiedenen Winkelpositionen zur Leiterplatine und zum Testkontaktor ausgerichtet werden kann, ohne dass die versteifende Funktion bzw. die unterstützende Funktion, insbesondere durch den Auflageabschnitt, beeinträchtigt wird. Mit anderen Worten kann das Versteifungselement in einer gedachten Ebene die im Wesentlichen parallel zu einer Ebene ist, in der sich die Leiterplatine erstreckt, verdreht angeordnet werden, ohne dass die versteifende Funktion bzw. die unterstützende Funktion, insbesondere durch den Auflageabschnitt, beeinträchtigt wird.

Vorzugsweise sind vier Befestigungselemente in dem Versteifungselement, insbesondere in der zumindest einen Ausnehmung angeordnet. Bevorzugt ist dabei jedes der vier Befestigungselemente in einer Ausnehmung angeordnet. Mit anderen Worten ist bevorzugt ein Befestigungselement in jeweils einer Ausnehmung angeordnet, so dass eine Anzahl von Befestigungselementen einer Anzahl von Ausnehmung entspricht.

Vorteilhafterweise ermöglichen die vier Befestigungselemente in der zumindest einen Ausnehmung einerseits eine sichere Ausrichtung des Versteifungselements zur Leiterplatine und zum Testkontaktor, und andererseits eine besonders sichere Verbindung zwischen dem Versteifungselement und dem Testkontaktor. Das zumindest eine Befestigungselement, vorzugsweise alle Befestigungselemente können dazu mit Gewinden ausgebildet sein, insbesondere auch Schrauben sein. Beispielsweise können die Befestigungselemente auch als rohrförmige Elemente mit Innengewinden ausgebildet sein. Während alle Befestigungselemente mit Innen- oder Außengewinden konfiguriert sein können, besteht auch die Möglichkeit nur einen Teil einer Anzahl von in der mindestens einen Ausnehmung angeordneten Befestigungselementen mit Innen- oder Außengewinden zu versehen. So können einzelne Befestigungselemente der Anzahl von in der mindestens einen Ausnehmung angeordneten Befestigungselementen auch als Bolzen oder rohrförmiges Element(e) ausgebildet sein, um den Montageaufwand zu verringern und somit die Montage des Testkontaktorsystems weiter zu vereinfachen bzw. zu erleichtern.

Die Befestigungsgegenelemente des Testkontaktors sind im allgemeinen komplementär zu den Befestigungselementen, wie durch das Versteifungselement bereitgestellt, konfiguriert. Werden durch das Versteifungselement verschiedene Befestigungselemente bereitgestellt, und demgemäß auch verschiedene Befestigungsgegenelemente durch den Testkontaktor bereitgestellt, so ermöglicht dies vorteilhaft bei der Ausrichtung durch die komplementären Paarungen zwischen den Befestigungselementen und den komplementären Befestigungsgegenelementen integral eine Codierung vorzunehmen, so dass der Testkontaktor nur vorbestimmt bzw. vordefiniert bzw. vorausgerichtet mit dem Versteifungselement verbunden werden kann. Somit wird vorteilhafterweise ermöglicht, eine zielgerichtete und vordefinierte Montage des Testkontaktorsystems in der richtigen Ausrichtung bzw. Position sicherzustellen.

Ein weiterer Aspekt der Erfindung betrifft eine Verwendung eines Versteifungselements gemäß eines der vorbeschriebenen Aspekte und bevorzugten Ausführungsformen, um eine Leiterplatine in einem Testkontaktorsystem zu versteifen, wobei das Testkontaktorsystem das Versteifungselement, die Leiterplatine und einen Testkontaktor aufweist.

Ein weiterer Aspekt der Erfindung betrifft ein Verfahren zur Montage eines Testkontaktorsystems, aufweisend die Schritte:
- Bereitstellen einer Leiterplatine,
- Fixieren eines Versteifungselements, gemäß einem der vorstehenden Aspekte und bevorzugten Ausführungsformen, an der Leiterplatine,
- Anordnen eines Testkontaktors an einer Seite der Leiterplatine, die dem Versteifungselement gegenüber liegt, und
- lösbares bzw. wiederlösbares Befestigen des Testkontaktors an dem Versteifungselement mittels zumindest einem Befestigungsgegenelement, welches komplementär zu zumindest einem Befestigungselement des Versteifungselements ist.

Im Folgenden werden Ausführungsformen der Erfindung anhand der beiliegenden Figuren näher beschrieben. Es versteht sich, dass die vorliegende Erfindung nicht auf diese Ausführungsformen beschränkt sind, und dass einzelne Merkmale der Ausführungsformen im Rahmen der beiliegenden Ansprüche zu weiteren Ausführungsformen kombiniert werden können.

Es zeigt:
- Figur 1: eine perspektivische Skizze eines Versteifungselements;
- Figur 2: eine perspektivische Skizze eines Versteifungselements mit Sicht von unten;
- Figur 3: eine perspektivische Skizze eines Versteifungselements, das mit einer Leiterplatine vormontiert ist;
- Figur 4: eine perspektivische Skizze, ähnlich zu Figur 3, wobei zusätzlich zwei Befestigungsgegenelemente des Testkontaktors mit dargestellt sind;
- Figur 5: eine perspektivische Skizze eines Testkontaktorsystems in geöffnetem Zustand;
- Figur 6: eine perspektivische Skizze eines Testkontaktorsystems in geschlossenem Zustand;
- Figur 7: eine Schnittdarstellung eines Testkontaktorsystems in geschlossenem Zustand; und
- Figur 8: ein Flussdiagramm zur Montage eines Testkontaktorsystems.

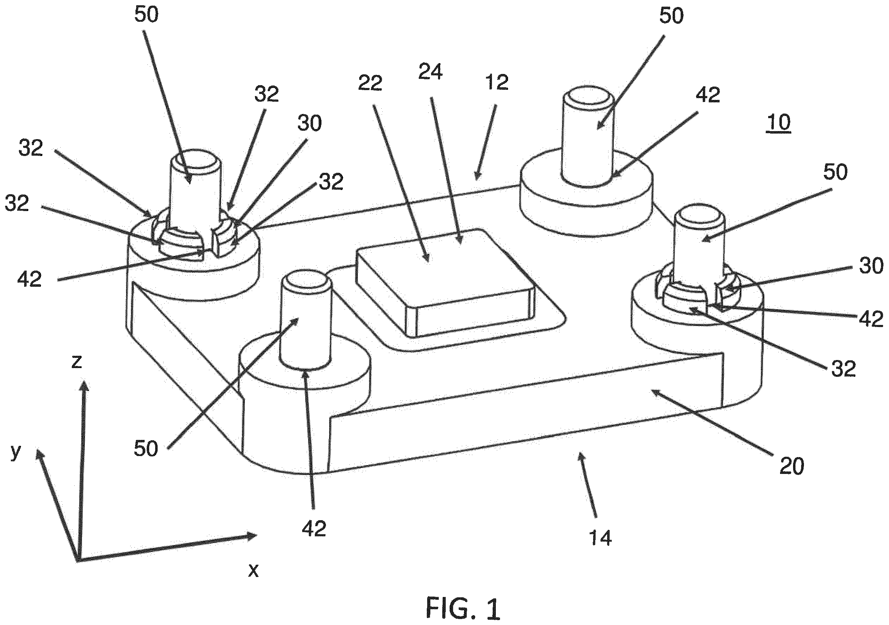

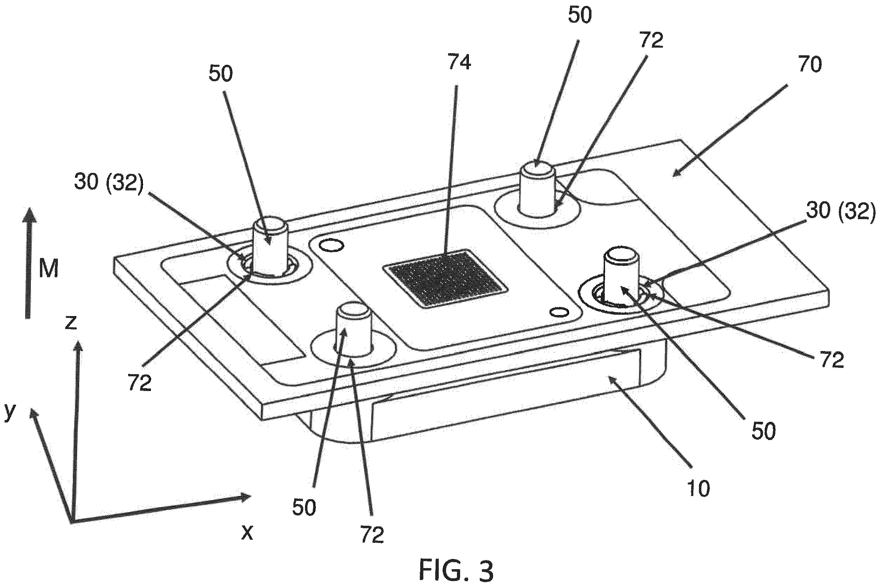

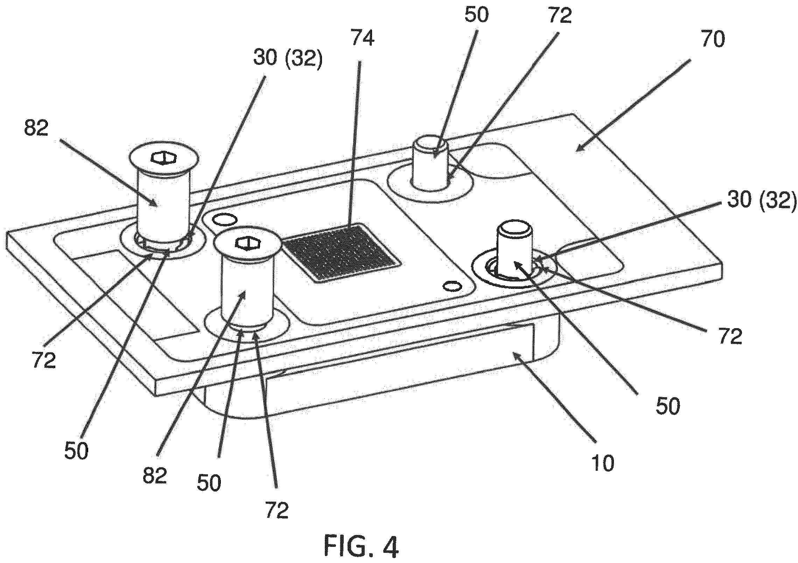

Fig. 1 zeigt eine perspektivische Skizze eines Versteifungselements 10, wobei in dem Versteifungselement 10 vier Befestigungselemente 50 angeordnet sind, die von Öffnungen 42 nach oben bzw. in z-Richtung hervorstehen. Weiterhin ist in Fig. 1 ein Auflageabschnitt 22 gezeigt, der als Auflageelement 24 ausgebildet ist und in dem Versteifungselement 10 an einer Platinenstützseite 12 des Versteifungselements 10 angeordnet bzw. in das Versteifungselement 10 eingesetzt ist. Außerdem zeigt Fig. 1 beispielhaft Fixierelemente 30, die als Fixiervorsprünge 32 ausgebildet sein können und sich im Wesentlichen in z-Richtung, ausgehend von dem Versteifungselement 10, erstrecken. Die Fixierelemente 30 können dabei, wie in Fig. 1 gezeigt, direkt an den Rändern der Öffnungen 42, wo die Befestigungselemente 50 hindurchtreten, ansetzen. Dadurch besteht die Möglichkeit, die Fixierelemente 30 bzw. die Fixiervorsprünge 32 so zu konfigurieren, dass die Befestigungselemente 50 beim Hindurchtreten durch die Öffnungen 42 die Fixierelemente 30 bzw. die Fixiervorsprünge 32 radial nach außen drücken oder sogar aufspreizen, so dass eine Fixierung des Versteifungselements an einer in den Fig. 3 und 4 gezeigten Leiterplatine verstärkt und somit verbessert wird.

Obwohl in Fig. 1 vier Befestigungselemente 50, vier Öffnungen 42, zwei Fixierelemente 30 die jeweils aus vier Fixiervorsprüngen 32 gebildet sind und ein Auflageabschnitt 22 der aus einem Auflageeinsatzelement 24 gebildet ist, dargestellt sind, kann ein erfindungsgemäßes Versteifungselement 10 von dieser zahlenmäßigen Ausgestaltung abweichen.

So kann ein erfindungsgemäßes Versteifungselement 10 beispielsweise eine Zahl von 1 bis 20 Befestigungselementen 50, Öffnungen 42 und Fixierelementen 30 aufweisen, wobei wahlweise insbesondere die Befestigungselemente 50 und/oder die Fixierelemente 30 sowohl integral mit dem Versteifungselement 10 ausgebildet sein können, oder auch als separate Elemente in bzw. an dem Versteifungselement 10 angeordnet sein können.

Auch der Auflageabschnitt 22, der in Fig. 1 an der Platinenstützseite 12 des Versteifungselements 10 als ein Auflageeinsatzelement 24 gezeigt ist, kann beispielsweise auch aus mehreren Auflageeinsatzelementen 24 gebildet sein. Weiterhin kann der Auflageabschnitt 22 integral als einer oder mehrere Auflageabschnitte 22 mit dem Versteifungselement 10 hergestellt und geformt werden, oder darüber hinaus auch separat als eines oder mehrere Auflageeinsatzelemente 24, welche in das Versteifungselement 10 einsetzbar bzw. damit verbindbar sind, ausgestaltet sein. Während die integrale Herstellung bzw. Formung des Auflageabschnitts 22 mit dem Versteifungselement 10 eine günstige Herstellung bzw. Fertigung ermöglicht, erlaubt die separate Bereitstellung des Auflageabschnitts 22 als eines oder mehrere Auflageeinsatzelemente 24, anwendungsspezifische Materialien für das eine oder die mehreren Auflageeinsatzelemente 24, als Auflage für eine Leiterplatine 70 zu verwenden, wodurch die Versteifung der Leiterplatine 70 verändert, insbesondere verbessert, werden kann.

Der Auflageabschnitt 22 der eine Auflage für die Leiterplatine 70 bildet kann beispielsweise so konfiguriert sein, dass die Leiterplatine 70 bei der Montage von Versteifungselement 10 und Leiterplatine 70 bündig mit dem Auflageabschnitt 22 in Kontakt kommt. Beispielsweise kann der Auflageabschnitt 22 auch so konfiguriert sein, dass bei der Montage von Versteifungselement 10 und Leiterplatine 70 ein vordefinierter Spalt verbleibt, der sich erst während des Testvorgangs des Testkontaktorsystems schließt.

Die Befestigungselemente 50, wie in Fig. 1 gezeigt, können, wie bereits oben erwähnt, integral mit dem Versteifungselement 10 hergestellt bzw. geformt werden, oder wahlweise auch als separate Befestigungselemente 50 ausgebildet sein, wie beispielsweise Schrauben mit Gewinden, Stifte ohne Gewinde. Weiterhin können zwar alle Befestigungselemente 50 gleich ausgebildet sein, es müssen jedoch nicht alle Befestigungselemente 50 gleich ausgebildet sein, sondern können insbesondere verschieden konfiguriert sein, so dass einzelne Befestigungselemente 50 einer möglichen Mehrzahl von Befestigungselementen 50 ein Gewinde, wie sie beispielsweise bei Schrauben verwendet werden, aufweisen und andere Befestigungselemente 50 lediglich als Stifte ausgebildet sind, die mit einem Über- oder Untermaß zu möglichen komplementären Befestigungsgegenelementen 82 konfiguriert sind.

Das Versteifungselement 10, wie in Fig. 1 gezeigt, kann als plattenförmiger Körper ausgebildet sein, der sich im Wesentlichen flach erstreckt, oder als konturierter Körper bzw. konturierte Struktur ausgebildet sein, die wahlweise verschiedene Erhebungen, Podeste bzw. Füße, oder ähnliches aufweist.

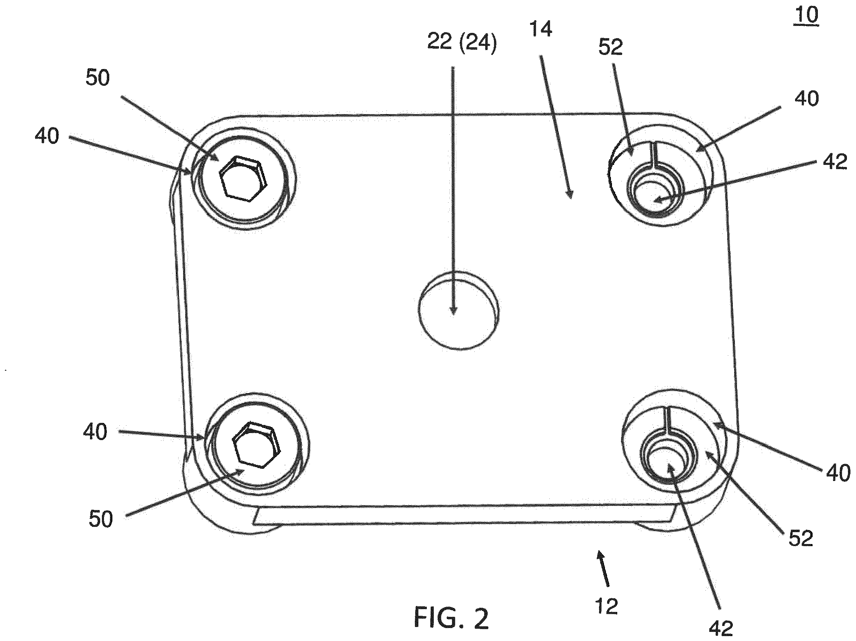

Fig. 2 zeigt eine perspektivische Skizze eines Versteifungselements 10 mit Sicht von unten. Das in Fig. 2 dargestellte Versteifungselement 10 weist vier Ausnehmungen 40 auf. In den beiden auf der linken Seite in Fig. 2 dargestellten Ausnehmungen 40 des Versteifungselements 10 sind Befestigungselemente 50 als darin angeordnet dargestellt. In den beiden auf der rechten Seite in Fig. 2 dargestellten Ausnehmungen 40 des Versteifungselements 10 sind Verliersicherungselemente 52 als darin angeordnet dargestellt. Weiterhin ist in der Rückseite 14 des Versteifungselements ein Loch gezeigt, auf dessen Gegenseite der Auflageabschnitt 22 bzw. das Auflageeinsatzelement 24 angeordnet ist.

Obwohl in Fig. 2 vier Ausnehmungen 40 im Versteifungselement 10 ausgebildet sind, können beispielsweise auch mehr oder weniger als vier Ausnehmungen 40 in dem Versteifungselement 10 ausgebildet sein. Beispielsweise können die Ausnehmungen 40 auch so ausgestaltet sein, dass mehr als ein Befestigungselement 50 darin angeordnet werden kann, insbesondere zwei bis sechs Befestigungselemente 50. Weiterhin weisen die in Fig. 2 dargestellten Ausnehmungen 40 einen kreisförmigen Querschnitt auf. Beispielsweise kann der Querschnitt der Ausnehmungen 40 im Versteifungselement 10 auch so konfiguriert sein, dass sich dieser entlang der z-Richtung, insbesondere in Richtung der Platinenstützseite 12 des Versteifungselements 10 verjüngt, also kleiner wird. Dadurch besteht wahlweise die Möglichkeit die Befestigungselemente 50 in die Ausnehmungen 40 einzupressen, wodurch Befestigungselemente 50 beispielsweise sowohl verliersicher als auch drehfest in Ausnehmungen 40 angeordnet werden können. Beispielsweise können Ausnehmungen 40 im Querschnitt auch als Vieleck, insbesondere als Rechteck oder als Sechseck, ausgeführt sein, um durch eine dazu komplementäre vieleckige, insbesondere rechteckige oder sechseckige, Ausbildung der Befestigungselemente 50, die Befestigungselemente 50 drehfest in den Ausnehmungen 40 anzuordnen. So können beispielsweise metrische Schrauben mit sechseckigen Schraubenkopf als Befestigungselement 50 in einer sechseckigen Ausnehmung 40 angeordnet werden, um das Befestigungselement 50 drehfest in der Ausnehmung 40 anzuordnen.

Um beispielhafte Verliersicherungselemente 72 in Fig. 2 sichtbar zu machen, sind in den Ausnehmungen 40 des Versteifungselements 10 auf der rechten Seite in Fig. 2 keine Befestigungselemente 50 mit dargestellt. In den Ausnehmungen 40 auf der linken Seite in Fig. 2 befinden sich bevorzugt ebenfalls Verliersicherungselemente 52, die dazu dienen die Befestigungselemente 50 verliersicher in den Ausnehmungen 40 anzuordnen. Die Verliersicherungselemente 72 können dabei als Sicherungsringe, Sprengringe, oder ähnliches ausgebildet sein. Weitere Möglichkeiten zur verliersicheren Anordnung der Befestigungselemente 50 in den Ausnehmungen 40 können beispielsweise Adhäsive sein, die zwischen den Befestigungselementen 50 und den Ausnehmungen 40 ein- bzw. aufgebracht werden.

Fig. 3 zeigt eine perspektivische Skizze eines Versteifungselements 10, das mit einer Leiterplatine 70 vormontiert ist. Insbesondere erfolgt die Montage bzw. Vormontage des Versteifungselements 10 mit der Leiterplatine 70, wie in Fig. 3 dargestellt, in z-Richtung bzw. in Montagerichtung M. Die Leiterplatine 70 kann zur Montage dabei Leiterplatinenöffnungen 72 aufweisen, die entsprechend der Fixierelemente 30 und/oder entsprechend der Befestigungselemente 50 an der Leiterplatine 70 ausgerichtet sein können, so dass die Befestigungselemente 50 problemlos bei der Montage bzw. Vormontage durch die Leiterplatinenöffnungen 72 hindurchtreten können, wodurch die Befestigungselemente 50 für die weitere Montage leicht zugänglich sind. Die Leiterplatine 70 in Fig. 3 weist einen Testbereich 74 auf, worauf während eines Testdurchlaufs des Testkontaktorsystems Federkontaktstifte 84 drücken, wobei der Druck über die Leiterplatine 70 an den Auflageabschnitt 22 des Versteifungselements 10 weitergegeben wird.

Wie in Fig. 3 bei der links oberen Leiterplatinenöffnung 72 und der rechts unteren Leiterplatinenöffnung 72 dargestellt, kann das Versteifungselement 10 mittels der Fixierelemente 30 bzw. der Fixiervorsprünge 32 an der Leiterplatine fixiert werden. In Fig. 3 ist dabei insbesondere ein Reibschluss dargestellt, wobei die Fixierelemente 30 bzw. die Fixiervorsprünge 32 durch die Leiterplatinenöffnungen 72 eingeklemmt werden. Beispielsweise können die Fixierelemente 30 bzw. die Fixiervorsprünge 32 auch als Cliparme mit Rückhaltevorsprüngen ausgebildet sein, wobei der Rückhaltevorsprung die Leiterplatine 70 bzw. eine Leiterplatinenöffnung 72 in der Dickenrichtung der Leiterplatine 70 hintergreift, wodurch sich ein Formschluss zwischen den Fixierelement(en) 30 bzw. den Fixiervorsprüngen 32, wie vom Versteifungselement 10 bereitgestellt, und der Leiterplatine 70 als Fixierung ausbildet.

Durch die Fixierung des Versteifungselements 10 an der Leiterplatine 70, mittels der Fixierelemente 30 bzw. Fixiervorsprünge 32, wird das Versteifungselement 10 an der Leiterplatine 70 derart fixiert, dass diese einen vorkonfektionierten bzw. vormontierten Zustand ausbilden, wodurch eine einfache Handhabung des vormontierten Versteifungselements 10 mit Leiterplatine 70 ermöglicht wird bzw. die weitere Montage mit dem Testkontaktor erleichtert wird.

Fig. 4 zeigt eine perspektivische Skizze, ähnlich zu Fig. 3, in der das Versteifungselement 10 mit der Leiterplatine 70 vormontiert bzw. vorkonfektioniert ist, wobei zusätzlich zwei Befestigungsgegenelemente 82 des Testkontaktors 80 mit dargestellt sind. Der Testkontaktor 80 selbst ist in Fig. 4 noch nicht dargestellt, stellt jedoch grundsätzlich die Befestigungsgegenelemente 82 bereit. Mit anderen Worten wird der Testkontaktor 80 zusammen, also gleichzeitig, mit den Befestigungsgegenelementen 82 an dem vormontierten System aus Versteifungselement 10 und Leiterplatine 70 montiert. Insbesondere wird der Testkontaktor 80 mittels der Befestigungsgegenelemente 82 an den Befestigungselementen 50 und somit an dem Versteifungselement 10, bzw. dem vormontierten System bzw. Subsystem aus Versteifungselement 10 und Leiterplatine 70, montiert.

Wie in Fig. 4 verdeutlicht, wird durch die durch die Leiterplatinenöffnungen 72 hervorstehenden Befestigungselemente 50 und die gleichzeitige Fixierung des Versteifungselements 10 an der Leiterplatine 70 mittels der Fixierelemente 30 bzw. der Fixiervorsprünge 32, eine besonders einfache Montage der Befestigungsgegenelemente 82 und damit des Testkontaktors 80 an das vormontierte System aus Versteifungselement 10 und Leiterplatine 70 ermöglicht. Bei der Montage des Befestigungsgegenelements 82 mit dem Befestigungselement 50, wie in Fig. 4 gezeigt, ist eine Zugänglichkeit der Befestigungselemente 50 von oben, bzw. in Montagerichtung M, gut gegeben. Die Montage der Befestigungsgegenelemente 82 bzw. des Testkontaktors 80 kann beispielsweise durch die vorbeschriebenen Eigenschaften der verliersicheren Anordnung der Befestigungselemente 50 in wahlweiser Kombination mit der drehsicheren Anordnung der Befestigungselemente 50 weiterhin vereinfacht bzw. verbessert werden, da die Befestigungselemente 50 weder von der Rückseite 14 des Versteifungselements 10 zugänglich sein müssen, noch festgehalten werden müssen, um beispielsweise mit den Befestigungsgegenelementen 82 verschraubbar zu sein.

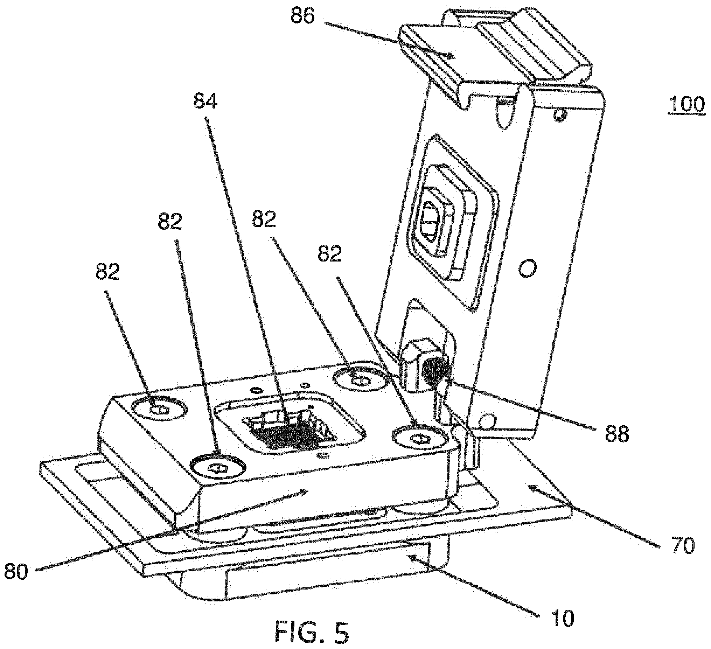

In Fig. 5 ist eine perspektivische Skizze eines Testkontaktorsystems 100 in geöffnetem Zustand gezeigt. Wie in Fig. 5 dargestellt, sind das Versteifungselement 10, die Leiterplatine 70 und der Testkontaktor 80 miteinander montiert. Weiterhin ist in Fig. 5 der Testkontaktor 80 in einem geöffneten Zustand gezeigt, wobei ein Oberteil des Testkontaktors 80 um ein Kontaktorscharnier 88 drehbar angeordnet ist und insbesondere durch Betätigung des Kontaktorverriegelungshebels 86 geschlossen werden kann, bzw. in einen geschlossenen Zustand überführt werden kann.

Wie in Fig. 5 dargestellt, sind eine Vielzahl von Federkontaktstiften 84 in dem Testkontaktor 80 angeordnet, auf die durch einen eingesetzten Chip und durch Schließen des Testkontaktors 80 Druck ausgeübt wird, wobei der Druck auf den Testbereich 74, wie in Fig. 4 gezeigt, weitergegeben wird. Dieser Druck auf den Testbereich 74 wird vom Testbereich 74 über den Auflageabschnitt 22 bzw. das Auflageeinsatzelement 24, wie in Fig. 1 gezeigt, auf das Versteifungselement 10 weitergegeben bzw. darauf übertragen, wodurch sich ein mögliches Durchbiegen der Leiterplatine 70 verringert, und somit das Testkontaktorsystem 100 und insbesondere die Leiterplatine 70 versteift werden.

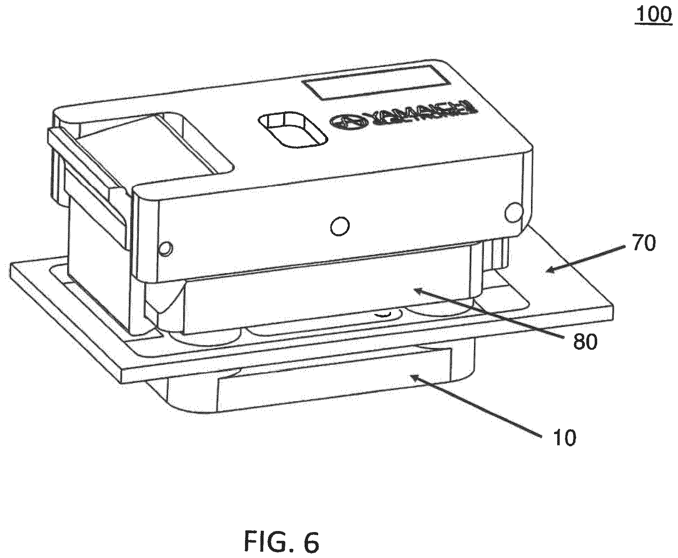

In Fig. 6 ist eine perspektivische Skizze eines Testkontaktorsystems 100 in geschlossenem Zustand gezeigt. Insbesondere ist der Kontaktorverriegelungshebel 86 verriegelt und, sofern ein Chip in den Testkontaktor 80 eingelegt wurde, wird dieser Chip mit Druck beaufschlagt. Gemäß der Beschreibung der Fig. 5, wird der Druck vom eingelegten Chip über die Federkontaktstifte 84, danach an die Leiterplatine 70, insbesondere den Testbereich 74 der Leiterplatine, und schließlich an das Versteifungselement 10, insbesondere den Auflageabschnitt 22 bzw. das Auflageeinsatzelement 24, weitergegeben bzw. übertragen und weitergeleitet.

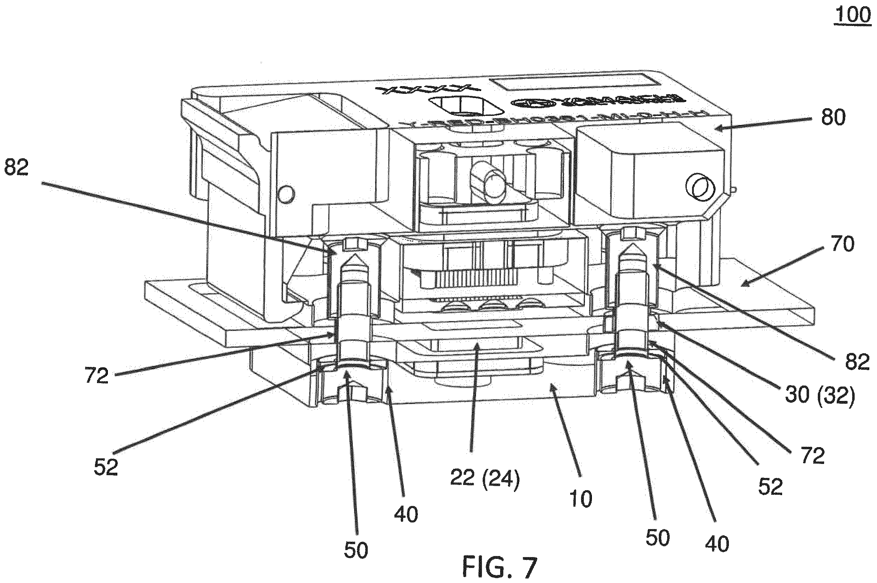

In Fig. 7 ist eine Schnittdarstellung eines Testkontaktorsystems 100 in geschlossenem Zustand gezeigt. Wie insbesondere auf der rechten Seite in Fig. 7 zu sehen, ist das Befestigungselement 50 in der Ausnehmung 40 angeordnet, wobei zusätzlich ein Verliersicherungselement 52 in der Ausnehmung 40 mit angeordnet ist, so dass das Befestigungselement 50 verliersicher in der Ausnehmung angeordnet ist. Oberhalb des Bereichs des Befestigungselements 50 der in der Ausnehmung 40, in der Schnittdarstellung aus Fig. 7, angeordnet ist, bzw. oberhalb des Befestigungselementsabschnitts der in der Ausnehmung 40 angeordnet ist, tritt bzw. erstreckt sich das Befestigungselement 50 durch die Leiterplatine 70, insbesondere durch eine Leiterplatinenöffnung 72 hindurch, wodurch das Befestigungselement 50 von der oberen Seite der Leiterplatine 70 bzw. von der Seite des Testkontaktors 80 her leicht zugänglich ist. Weiterhin ist das Versteifungselement 10, wie im Schnitt in Fig. 7 auf der rechten Seite gezeigt, mit einem Fixierelement 30 bzw. einem oder mehreren Fixiervorsprüngen 32 versehen, die sich nach oben, insbesondere in die Leiterplatinenöffnung 72 erstrecken, wodurch das Versteifungselement 10 an der Leiterplatine 70, bevorzugt reibschlüssig und/oder formschlüssig, fixiert wird. Dadurch kann das zum Befestigungselement 50 komplementäre Befestigungsgegenelement 82 von oben her mit dem Befestigungselement 50 besonders leicht bzw. einfach verbunden werden, ohne dass eine Zugänglichkeit des Befestigungselements 50 von unten nötig ist. Insbesondere kann für das Verbinden des Befestigungsgegenelements 82 mit dem Befestigungselement 50 auch ein Festhalten des Befestigungselements 50 nicht mehr nötig sein, beispielsweise in dem das Befestigungselement 50 drehfest am Versteifungselement 10, insbesondere der Ausnehmung 40, angeordnet ist.

Wie im Schnitt auf der rechten Seite in Fig. 7 angedeutet, ist das Befestigungselement 50 als Schraube mit Außengewinde konfiguriert und das Befestigungsgegenelement 82 als zu der Schraube mit Außengewinde komplementäre Hülse mit Innengewinde konfiguriert. Diese Anordnung kann auch umgekehrt sein, indem das Befestigungselement 50 als Hülse mit Innengewinde und das Befestigungsgegenelement 82 als zu der Hülse mit Innengewinde komplementäre Schraube mit Außengewinde ausgebildet ist. Beispielsweise können Befestigungselement 50 sowie komplementäres Befestigungsgegenelement 82, oder zumindest ein Teil der im Testkontaktorsystem 100 verwendeten Befestigungselemente 50 und Befestigungsgegenelemente 82 auch ohne Gewinde ausgebildet sein und stattdessen miteinander als Befestigungselement 50 und komplementäres Befestigungsgegenelement 82 eine Spiel- oder Presspassung ausbilden.

Weiterhin kann beispielsweise das zumindest eine Befestigungselement 50 in der zumindest einen Ausnehmung 40 direkt integral mit dem Versteifungselement 10 gefertigt werden, wodurch sich die Geometrien bzw. Querschnitte der Ausnehmungen 40 entsprechend der Geometrien bzw. Querschnitte der Befestigungselemente 50 ergeben, so dass zumindest ein Bereich des einen oder der mehreren Befestigungselemente vom Werkstoff des Versteifungsteils 10 umhüllt werden. Beispielsweise kann hierzu eine Schraube als Befestigungselement 50, ein Teil bzw. Bereich des Gewindes einer Schraube als Teil bzw. Bereich des Befestigungselements 50 und/oder ein Schraubenkopf als Teil bzw. Bereich des Befestigungselements 50 in der Ausnehmung 40 umspritzt werden. Mit anderen Worten kann ein Befestigungselementabschnitt, wie beispielsweise ein Schraubenkopf oder ein Gewindeabschnitt des Befestigungselements, in der Ausnehmung 40 umspritzt und somit vom Werkstoff des Versteifungsteils 10 umhüllt werden. Dies kann beispielsweise durch einen Mehrkomponentenspritzguss geschehen.

Alternativ können eine oder mehrere der Befestigungselemente 50 auch einstückig mit dem Versteifungselement 10 gefertigt werden, indem die Befestigungselemente 50 im gleichen bzw. selben Verfahren wie das Versteifungselement 10, beispielsweise im Spritzguss, hergestellt werden.

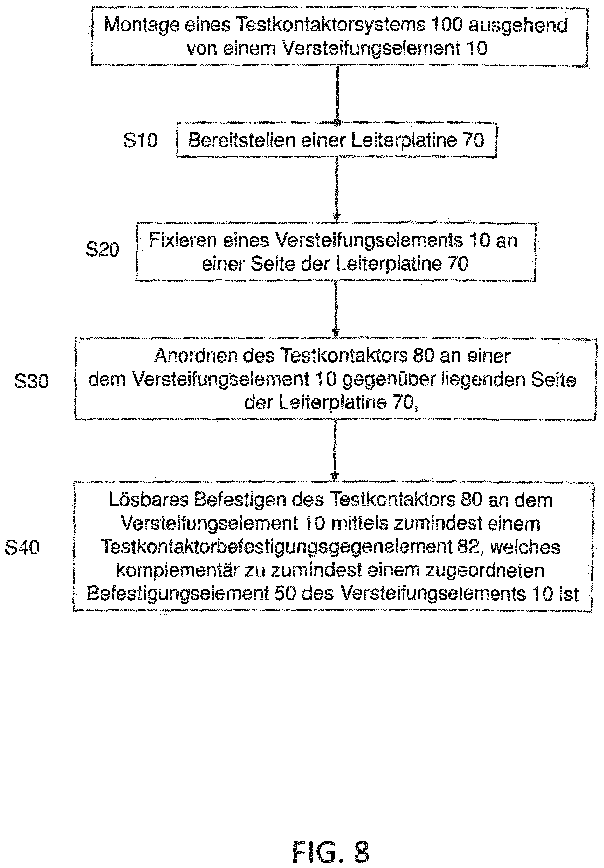

In Fig. 8 ist ein Flussdiagramm zur Montage eines Testkontaktorsystems 100, ausgehend von einem Versteifungselement 10, wie beispielsweise in den Fig. 1 und 2 gezeigt, dargestellt. Die Montage des Testkontaktorsystems 100 umfasst dabei insbesondere die folgenden Schritte:
S10: Bereitstellen einer Leiterplatine 70.
S20: Fixieren eines Versteifungselements 10 an der Leiterplatine 70.
S30: Anordnen des Testkontaktors 80 an einer Seite der Leiterplatine 70, die dem Versteifungselement 10 gegenüber liegt, und
S 40: Lösbares bzw. wiederlösbares Befestigen des Testkontaktors 80 an dem Versteifungselement 10 mittels zumindest einem Befestigungsgegenelement 82, welches komplementär zu zumindest einem Befestigungselement 50 des Versteifungselements 10 ist.

Durch die vorbeschriebene Montage des Testkontaktorsystems 100 besteht die Möglichkeit ein Testkontaktorsystem 100 bereitzustellen, welches mittels des Versteifungselements 10 versteift wird, welches sich gleichzeitig, wie oben ausgeführt, besonders leicht bzw. einfach mit der Leiterplatine 70 und im Weiteren auch mit dem Testkontaktor 80 montieren lässt.

### Bezugszeichenliste

- 10: Versteifungsteil
- 12: Platinenstützseite
- 14: Rückseite
- 20: Körper
- 22: Auflageabschnitt
- 24: Auflageeinsatzelement
- 30: Fixierelement
- 32: Fixiervorsprung
- 40: Ausnehmung
- 42: Öffnung
- 50: Befestigungselement
- 52: Verliersicherungselement
- 70: Leiterplatine
- 72: Leiterplatinenöffnung
- 74: Testbereich
- 80: Testkontaktor
- 82: Befestigungsgegenelement bzw. Testkontaktorbefestigungsgegenelement
- 84: Federkontaktstifte
- 86: Kontaktorverriegelungshebel
- 88: Kontaktorscharnier
- 100: Testkontaktorsystem
- M: Montagerichtung
- S10-S40: Schritte zur Montage eines Testkontaktorsystems

## Patentansprüche

1. Versteifungselement (10) zum Versteifen eines Testkontaktorsystems (100), umfassend:
- einen Auflageabschnitt (22) an einer Platinenstützseite (12) des Versteifungselements (10), wobei der Auflageabschnitt (22) ausgebildet ist, um eine Auflage für eine Leiterplatine (70) zu bilden; und
- zumindest eine Ausnehmung (40) an einer Rückseite (14) des Versteifungselements (10), wobei in der zumindest einen Ausnehmung (40) zumindest ein Befestigungselement (50) zur Befestigung des Versteifungselements (10) mit einem Testkontaktor (80) verliersicher angeordnet ist.
wobei das Versteifungselement (10) an der Platinenstützseite (12) zumindest ein Fixierelement (30) aufweist, um das Versteifungselement (10) an der Leiterplatine (70) zu fixieren.

2. Versteifungselement (10) nach Anspruch 1, wobei
- das zumindest eine Befestigungselement (50) durch zumindest eine Öffnung (42) in dem Versteifungselement (10) in Richtung der Platinenstützseite (12) des Versteifungselements (10) hindurchtritt,
- das zumindest eine Befestigungselement (50) konfiguriert ist, durch zumindest eine Leiterplatinenöffnung (72) durch die Leiterplatine (70) hindurchzutreten, und
- das zumindest eine Befestigungselement (50) mit zumindest einem komplementären Befestigungsgegenelement (82) des Testkontaktors (80) lösbar verbindbar ist.

3. Versteifungselement (10) nach Anspruch 1 oder 2, wobei das zumindest eine Befestigungselement (50) drehfest in der zumindest einen Ausnehmung (40) angeordnet ist.

4. Versteifungselement (10) nach einem der Ansprüche 1 bis 3, wobei das zumindest eine Fixierelement (30) als eine Mehrzahl von Fixiervorsprüngen (32) ausgebildet ist, die in einer Montagerichtung (M) hin zu der Leiterplatine (70) ausgehend von dem Versteifungselement (10) vorstehen, wobei
- das Versteifungselement (10) mittels der Mehrzahl von Fixiervorsprüngen (32) reibschlüssig mit der Leiterplatine (70) verbindbar ist, und/oder
- das Versteifungselement (10) mittels der Mehrzahl von Fixiervorsprüngen (32) formschlüssig mit der Leiterplatine (70) verbindbar ist.

5. Versteifungselement (10) nach Anspruch 2, wobei das zumindest eine Fixierelement (30) direkt am Rand der zumindest einen Öffnung (42) in dem Versteifungselement (10), wo das zumindest eine Befestigungselement (50) hindurchtritt, ansetzt.

6. Versteifungselement (10) nach einem der Ansprüche 1 bis wobei die zumindest eine Ausnehmung (40) vier Ausnehmungen (40) umfasst, die auf der Rückseite des Versteifungselements (10) ausgebildet sind, wobei
- die vier Ausnehmungen (40)
- - rechteckig, insbesondere quadratisch, oder
- - vieleckig, insbesondere sechseckig, oder
- - kreisförmig
an der Rückseite (14) des Versteifungselements (10) ausgebildet sind, und wobei
- vorzugsweise der Auflageabschnitt (22) geometrisch mittig zu den vier Ausnehmungen (40) angeordnet ist.

7. Versteifungselement (10) nach einem der Ansprüche 1 bis 6, wobei das zumindest eine Befestigungselement (50) vier Befestigungselemente (50) umfasst.

8. Verwendung eines Versteifungselements (10) nach einem der Ansprüche 1 bis 7, um eine Leiterplatine (70) in einem Testkontaktorsystem (100), aufweisend das Versteifungselement (10), die Leiterplatine (70) und einen Testkontaktor (80), zu versteifen.

9. Verfahren zur Montage eines Testkontaktorsystems (100), umfassend die Schritte:
- Bereitstellen einer Leiterplatine (70),
- Fixieren eines Versteifungselements (10) gemäß einem der Ansprüche 1 bis 7 an einer Seite der Leiterplatine (70),
- Anordnen eines Testkontaktors (80) an einer dem Versteifungselement (10) gegenüber liegenden Seite der Leiterplatine (70), und
- lösbares Befestigen des Testkontaktors (80) an dem Versteifungselement (10) mittels zumindest eines Testkontaktorbefestigungsgegenelements (82), welches komplementär zu dem zumindest einen zugeordneten Befestigungselement (50) des Versteifungselements (10) ist.

## Claims

1. Reinforcement element (10) for reinforcing a test contactor system (100), comprising:
- a support portion (22) on a circuit-board bearing face (12) of the reinforcement element (10), wherein the support portion (22) is configured to form a support for a printed circuit board (70), and
- at least one recess (40) on a rear face (14) of the reinforcement element (10), wherein at least one fastening element (50) for fastening the reinforcement element (10) to a test contactor (80) is arranged in the at least one recess (40) such that it cannot be lost,
wherein the reinforcement element (10) comprises at least one fixing element (30) on the circuit-board bearing face (12) in order to fix the reinforcement element (10) to the printed circuit board (70).

2. Reinforcement element (10) according to claim 1, wherein
- the at least one fastening element (50) passes through at least one opening (42) in the reinforcement element (10) towards the circuit-board bearing face (12) of the reinforcement element (10),
- the at least one fastening element (50) is configured to pass through the printed circuit board (70) through at least one printed-circuit-board opening (72), and
- the at least one fastening element (50) can be detachably connected to at least one complementary mating fastening element (82) of the test contactor (80).

3. Reinforcement element (10) according to claim 1 or 2, wherein the at least one fastening element (50) is non-rotatably arranged in the at least one recess (40).

4. Reinforcement element (10) according to any of claims 1 to 3, wherein the at least one fixing element (30) is configured as a plurality of fixing projections (32), which project from the reinforcement element (10) in a mounting direction (M) towards the printed circuit board (70), wherein
- the reinforcement element (10) can be frictionally connected to the printed circuit board (70) by means of the plurality of fixing projections (32), and/or
- the reinforcement element (10) can be interlockingly connected to the printed circuit board (70) by means of the plurality of fixing projections (32).

5. Reinforcement element (10) according to claim 2, wherein the at least one fixing element (30) is positioned directly on the edge of the at least one opening (42) in the reinforcement element (10), where the at least one fastening element (50) passes through.

6. Reinforcement element (10) according to any of claims 1 to 5, wherein the at least one recess (40) comprises four recesses (40), which are formed on the rear face of the reinforcement element (10), wherein
- the four recesses (40) are formed to be
- - rectangular, in particular square, or
- - polygonal, in particular hexagonal, or
- - circular
on the rear face (14) of the reinforcement element (10), and wherein
- the support portion (22) is preferably arranged geometrically centrally relative to the four recesses (40).

7. Reinforcement element (10) according to any of claims 1 to 6, wherein the at least one fastening element (50) comprises four fastening elements (50).

8. Use of a reinforcement element (10) according to any of claims 1 to 7 to reinforce a printed circuit board (70) in a test contactor system (100), comprising the reinforcement element (10), the printed circuit board (70) and a test contactor (80).

9. Method for mounting a test contactor system (100), comprising the steps of:
- providing a printed circuit board (70),
- fixing a reinforcement element (10) according to any of claims 1 to 7 to one face of the printed circuit board (70),
- arranging a test contactor (80) on a face of the printed circuit board (70) opposite the reinforcement element (10), and
- detachably fastening the test contactor (80) to the reinforcement element (10) by means of at least one mating test-contactor fastening element (82), which is complementary to the at least one associated fastening element (50) of the reinforcement element (10).

## Revendications

1. Un élément raidisseur (10) pour raidir un système de contacteur de test (100), comprenant :
- une portion de soutien (22) sur un côté de soutien de carte (12) de l'élément raidisseur (10), la portion de soutien (22) étant adaptée pour former un support pour une carte de circuit imprimé (70) ; et
- au moins un évidement (40) sur une face arrière (14) de l'élément raidisseur (10), sachant que dans l'au moins un évidement (40) au moins un élément de fixation (50) pour la fixation de l'élément raidisseur (10) au contacteur de test (80) est disposé de façon imperdable,
sachant que l'élément raidisseur (10) présente sur le côté de soutien de carte (12), au moins un élément de fixation (30) pour fixer l'élément raidisseur (10) à la carte de circuit imprimé (70).

2. L'élément raidisseur (10) d'après la revendication 1, sachant que
- l'au moins un élément de fixation (50) passe à travers au moins une ouverture (42) dans l'élément raidisseur (10) en direction du côté de soutien de carte (12) de l'élément raidisseur (10),
- l'au moins un élément de fixation (50) est configuré pour passer à travers au moins une ouverture de carte de circuit imprimé (72) à travers la carte de circuit imprimé (70), et que
- l'au moins un élément de fixation (50) peut être relié de manière amovible à au moins un contre-élément de fixation (82) complémentaire du contacteur de test (80).

3. L'élément raidisseur (10) d'après la revendication 1 ou 2, sachant que l'au moins un élément de fixation (50) est disposé de manière solidaire en rotation dans l'au moins un évidement (40).

4. L'élément raidisseur (10) d'après l'une des revendications de 1 à 3, sachant que l'au moins un élément de fixation (30) est réalisé sous la forme d'une pluralité de saillies de fixation (32) qui font saillie dans une direction de montage (M) vers la carte de circuit imprimé (70) en partant de l'élément raidisseur (10), sachant que
- l'élément raidisseur (10) peut être relié par friction à la carte de circuit imprimé (70) au moyen de la pluralité de saillies de fixation (32), et/ou que
- l'élément raidisseur (10) peut être relié par conjugaison de forme à la carte de circuit imprimé (70) au moyen de la pluralité de saillies de fixation (32).

5. L'élément raidisseur (10) d'après la revendication 2, sachant que l'au moins un élément de fixation (30) s'applique directement au bord de l'au moins une ouverture (42) dans l'élément raidisseur (10), par laquelle passe l'au moins un élément de fixation (50).

6. L'élément raidisseur (10) d'après l'une des revendications de 1 à 5, sachant que l'au moins un évidement (40) comprend quatre évidements (40) formés sur la face arrière de l'élément raidisseur (10), sachant que
- les quatre évidements (40) sont de forme
-- rectangulaire, notamment carrée, ou
-- polygonale, notamment hexagonale, ou
-- circulaire
sur la face arrière (14) de l'élément raidisseur (10), et sachant que
- de préférence, la portion de soutien (22) est agencée géométriquement au centre des quatre évidements (40).

7. L'élément raidisseur (10) d'après l'une des revendications de 1 à 6, sachant que l'au moins un élément de fixation (50) comprend quatre éléments de fixation (50).

8. Utilisation d'un élément raidisseur (10) d'après l'une des revendications de 1 à 7 pour rigidifier une carte de circuit imprimé (70) dans un système de contacteur de test (100) présentant l'élément raidisseur (10), la carte de circuit imprimé (70) et un contacteur de test (80).

9. Un procédé d'assemblage d'un système de contacteur de test (100), comprenant les étapes suivantes :
- fournir une carte de circuit imprimé (70),
- fixer un élément raidisseur (10) d'après l'une des revendications de 1 à 7 sur une face de la carte de circuit imprimé (70),
- agencer un contacteur de test (80) sur un côté de la carte de circuit imprimé (70) opposé à l'élément raidisseur (10), et
- fixer de manière amovible le contacteur de test (80) à l'élément raidisseur (10) au moyen d'au moins un contre-élément de fixation de contacteur de test (82) qui est complémentaire à l'au moins un élément de fixation (50) associé de l'élément raidisseur (10).
